# EUROPÄISCHE PATENTANMELDUNG

(11) **EP 4 383 572 A1**
(43) Veröffentlichungstag der Anmeldung: **12.06.2024**
(21) Anmeldenummer: 23205568.1
(22) Anmeldetag: 24.10.2023
(51) Int. Cl.: H03K 17/95

(54) **SENSORANORDNUNG FÜR INDUKTIVE SENSOREN, VERKAUFS- ODER RÜCKNAHMEAUTOMAT UND VERFAHREN ZUR HERSTELLUNG EINER SENSORANORDNUNG**

(30) Priorität: 09.12.2022 DE 102022213394; 05.05.2023 DE 102023111691
(71) Anmelder: Sielaff GmbH & Co. KG Automatenbau Herrieden, 91567 Herrieden (DE)
(72) Erfinder: RAUH, Dennis, 91567 Herrieden (DE); KRAWCZYK, Andreas Kamil, 91589 Aurach (DE); HIEMEYER, Marco, 91632 Wieseth (DE); BEYERLEIN, Tobias, 91734 Mitteleschenbach (DE)
(74) Vertreter: Isarpatent

(57) **Zusammenfassung**

Die vorliegende Erfindung betrifft eine Sensoranordnung für induktive Sensoren, mit einer metallischen Basis, und mit zumindest einem nichtbündigen induktiven Sensor, wobei der zumindest eine nichtbündige Sensor im Wesentlichen bündig in oder an dem Metall der metallischen Basis angeordnet ist, und wobei ein vorbestimmtes extern angelegtes oder anlegbares Magnetfeld an dem Sensor vorgesehen ist. Die vorliegende Erfindung betrifft ferner einen Verkaufs- oder Rücknahmeautomat und ein Verfahren zur Herstellung einer Sensoranordnung in einem oder für einen Verkaufs- oder Rücknahmeautomaten.

## Beschreibung

### GEBIET DER ERFINDUNG

Die vorliegende Erfindung betrifft eine Sensoranordnung für induktive Sensoren, insbesondere für einen Verkaufs- oder Rücknahmeautomaten, einen entsprechenden Verkaufs- oder Rücknahmeautomaten sowie ein Verfahren zur Herstellung einer Sensoranordnung in einem oder für einen Verkaufs- oder Rücknahmeautomaten.

### TECHNISCHER HINTERGRUND

Induktive Sensoren funktionieren auf dem Prinzip einer Änderung von Induktivität aufgrund einer Interaktion mit einem Objekt, das diese Änderung bewirkt. In diesem Sinne erzeugen induktive Sensoren ein Magnetfeld und ein leitfähiges und/oder ferromagnetisches Objekt verändert dieses Magnetfeld. Eine Untergruppe der induktiven Sensoren sind die induktiven Näherungsschalter, die berührungslos leitfähige Objekte detektieren können, um ein entsprechendes binäres Signal auszusenden. Aus diesem Grund werden derartige induktiven Näherungsschalter oftmals zum Detektieren von Metallobjekten eingesetzt, die sich in ihrem Messfeld bewegen.

Induktive Sensoren existieren in zwei verschiedene Einbauarten. Induktive Sensoren können bündig eingebaut werden, wobei diese Sensoren komplett bis zu ihrer obersten Sensoroberfläche innerhalb dem umgebenen Metall angeordnet werden. Diese komplette Versenkung der Sensoren im Umgebungsmaterial hat den Vorteil, dass die Sensoren weniger Schmutzablagerungen und mechanische Belastungen erfahren. Ein Nachteil ist allerdings, dass bündige Sensoren einen erheblich geringeren Schaltabstand aufweisen. Der geringere Schaltabstand der bündigen Sensoren resultiert aus der Einschränkung des Erkennungsbereichs aufgrund des umliegenden Materials.

Induktive Sensoren können alternativ auch nichtbündig bzw. vorstehend in einem Metall bzw. in einer Metallumgebung eingebaut werden. Eine derartige nichtbündige Einbauart von Sensoren ergibt zwar einen deutlich höheren Schaltabstand, jedoch wird ein gewisser Mindestabstand bzw. ein Freiraum zum nächstgelegenen leitfähigem Material benötigt um somit kein Dauersignal zu erzeugen.

Dies ist ein Zustand, den es zu verbessern gilt.

### ZUSAMMENFASSUNG DER ERFINDUNG

Vor diesem Hintergrund liegt der vorliegenden Erfindung die Aufgabe zugrunde, eine verbesserte Sensoranordnung von induktiven Sensoren anzugeben.

Erfindungsgemäß wird diese Aufgabe durch eine Sensoranordnung mit den Merkmalen des Patentanspruchs 1 und/oder durch einen Verkaufs- oder Rücknahmeautomaten mit den Merkmalen des Patentanspruchs 12 und/oder durch ein Verfahren mit den Merkmalen des Patentanspruchs 14 gelöst.

Gemäß einem ersten Aspekt beansprucht die Erfindung eine Sensoranordnung für induktive Sensoren, mit einer metallischen Basis, mit zumindest einem nichtbündigen induktiven Sensor, wobei der zumindest eine nichtbündige Sensor im Wesentlichen bündig in oder an dem Metall der metallischen Basis angeordnet ist, und wobei ein vorbestimmtes extern angelegtes oder anlegbares Magnetfeld an dem Sensor vorgesehen ist.

Gemäß einem zweiten Aspekt beansprucht die Erfindung einen Verkaufs- oder Rücknahmeautomaten, mit einer erfindungsgemäßen Sensoranordnung für induktive Sensoren.

Gemäß einem dritten Aspekt beansprucht die Erfindung ein Verfahren zur Herstellung einer Sensoranordnung in einem oder für einen Verkaufs- oder Rücknahmeautomaten mit den Schritten: Bereitstellen einer metallischen Basis, die zumindest einen Abschnitt einer Automatenfront bildet; Bereitstellen zumindest eines nichtbündigen induktiven Sensors; Anordnen des zumindest einen nichtbündigen induktiven Sensors im Wesentlichen bündig in oder an dem Metall der metallischen Basis; und Anlegen eines vorbestimmten externen Magnetfelds an dem Sensor.

Die der vorliegenden Erfindung zugrundeliegende Erkenntnis besteht darin, eine Beeinflussung des Erkennungsbereichs von induktiven Sensoren vorzusehen, um dadurch nichtbündige Sensoren möglichst bündig einzubauen.

Die der vorliegenden Erfindung zugrundeliegende Idee besteht darin, den Erkennungsbereich von nichtbündigen Sensoren mittels gerichteter Magnetfelder zu beeinflussen.

Erfindungsgemäß kann ein gezielt aufgebautes und vorbestimmtes Magnetfeld eine nahezu bündige Einbauform des nichtbündigen induktiven Sensors ermöglichen, wobei der Schaltabstand des Sensors nicht verringert wird. Ermöglicht wird dies durch das Prinzip der Addition bzw. Subtraktion von Magnetfeldlinien, bzw. das Superpositionsprinzip, das für derartige Magnetfelder gilt auch wie für Wellen. Das Superpositionsprinzip beschreibt die Auswirkung einer Überlagerung physikalischer Größen, wobei sich Magnetfelder aufgrund dessen gegenseitig beeinflussen können. Im Allgemeinen erzeugen induktive Sensoren und Magnete ein magnetisches Feld in ihrer Umgebung.

Vorteilhafterweise wird der Schaltabstand oder auch der Abstand innerhalb welchem der zumindest eine Sensor ein Objekt erkennen kann durch das vorbestimmte extern angelegte oder anlegbare Magnetfeld nicht verringert. Ferner kann der Schaltabstand auch als Erkennungsbereich des Sensors definiert werden, wobei der Erkennungsbereich einen Bereich umfasst, worin der Sensor ein Objekt, insbesondere metallisches Objekt, als solches erkennen kann. Zusätzlich kann Erfindungsgemäß der Erkennungsbereich derart beeinflusst werden, dass der Sensor nicht ungewollt auslöst. Beispielsweise aufgrund einer metallischen Komponenten, die in den Erkennungsbereich hineinragt oder innerhalb diesem angeordnet ist.

Die metallische Basis kann als strukturelle Basis ausgebildet sein, wobei die metallische Basis eine geeignete Fläche zur Aufnahme des zumindest einen Sensors aufweisen kann. Auf diese Weise wird eine geeignete Aufnahmefläche für den zumindest einen Sensor bereitgestellt. Insbesondere, kann die metallische Basis als ein dreidimensionales metallisches Gehäuse ausgebildet sein, wobei das Gehäuse im Wesentlichen hohl ist, und/oder ein freies Volumen aufweist.

Die erfindungsgemäße Anordnung des zumindest einen nichtbündige Sensors im Wesentlichen bündig in oder an dem Metall der metallischen Basis kann als eine Anordnung innerhalb eines Volumens der metallischen Basis verstanden werden. Insbesondere kann die erfindungsgemäße Anordnung des zumindest einen nichtbündige Sensors als Anordnung in der unmittelbaren Umgebung von anderen metallischen Bauteilen und/oder Komponenten verstanden werden. Hierbei können die anderen metallischen Bauteile und/oder Komponenten derart angeordnet sein, dass sie an dem zumindest einen nichtbündigen Sensor anliegen und/oder den zumindest einen nichtbündigen Sensor umgeben, insbesondere vollumfänglich. Die metallischen Bauteile und/oder Komponenten können als weitere Sensoren, Messtechnik, Gehäuseteile, Rahmenteile, usw. ausgebildet sein. Auf diese Weise wird eine im Wesentlichen bündige Anordnung bereitgestellt, worin ein herkömmlicher nichtbündiger Sensor aufgrund der besagten Anordnung ein Dauererkennungssignal übermitteln würde. Ferner kann die Anordnung des zumindest einen nichtbündige Sensors als zumindest teilweise Versenkung, insbesondere vollständige Versenkung, des Sensors in einem metallischen Vollmaterial verstanden werden.

Der zumindest eine nichtbündige induktive Sensor kann als induktiver Sensor der zum nichtbündigen Einbau eingesetzt wird ausgebildet sein. Insbesondere weist der nichtbündige induktive Sensor einen größeren Schaltabstand auf als ein induktiver Sensor der zum bündigen Einbau ausgebildet ist. Auf diese Weise, wird ein geeigneter Sensor bereitgestellt, der eine kompakte Bauform aufweist, metallische Objekte erkennen kann und einen hohen Schaltabstand aufweist. Zusätzlich kann der nichtbündige induktive Sensor als induktiver Funksensor ausgebildet sein. Ein derartiger induktiver Funksensor kann sein Ausgangssignal per Funk an einen Empfänger senden, der das Signal an eine Ausleseeinheit weiterleitet. Insbesondere ist der zumindest eine nichtbündige induktive Sensor als kabelgebundener Sensor ausgebildet.

Vorteilhafterweise, kann das vorbestimmte extern angelegte oder anlegbare Magnetfeld mit dem erzeugten Magnetfeld des zumindest einem nichtbündigen induktiven Sensors interagieren und/oder es beeinflussen. Insbesondere, basiert die Interkation oder die Beeinflussung auf das Superpositionsprinzip. Auf diese Weise kann das extern angelegte oder anlegbare Magnetfeld genutzt werden, um einen bündigen und/oder nahezu bündigen Einbau des nichtbündigen Sensors zu ermöglichen, indem das extern angelegte oder anlegbare Magnetfeld mit dem Magnetfeld des zumindest einen Sensors interagiert und ein Auslösen des nichtbündigen induktiven Sensors aufgrund des bündigen und/oder nahezu bündigen Einbaus in der metallischen Basis vermeidet.

Vorteilhafte Ausgestaltungen und Weiterbildungen ergeben sich aus den weiteren Unteransprüchen sowie aus der Beschreibung unter Bezugnahme auf die Figuren der Zeichnung.

Gemäß einer Ausführungsform weist die Sensoranordnung eine Magnetquelle auf, die zum Erzeugen des vorbestimmten Magnetfelds ausgebildet ist, wobei die Magnetquelle auf einer externen Oberfläche des Sensors angeordnet ist. Die Magnetquelle kann insbesondere als zumindest ein Elektromagnet und/oder Permanentmagnet ausgebildet sein. Alternativ kann die Magnetquelle in der unmittelbaren Nähe des Sensors, insbesondere in der Nähe der externen Oberfläche, angeordnet sein. Auf diese Weise wird eine aufwandsarm anzubringende Magnetquelle zur Erzeugung des Magnetfelds und eine geeignete Fläche zur Aufnahme der Magnetquelle bereitgestellt. Vorteilhafterweise wird eine aufwendige und kostenintensive Integration einer Magnetquelle innerhalb des zumindest einen Sensors vermieden.

Gemäß einer Ausführungsform ist das vorbestimmte Magnetfeld zur Beeinflussung eines Erkennungsbereichs des Sensors ausgelegt. Die Beeinflussung des Erkennungsbereichs des Sensors kann als Vergrößerung, Verkleinerung, Verformung und/oder vorbestimmte Ausrichtung des Erkennungsbereichs des zumindest einen induktiven Sensors ausgebildet sein. Insbesondere basiert die Beeinflussung eines Erkennungsbereichs des Sensors auf dem Superpositionsprinzip. Auf diese Weise wird eine effektive und aufwandsarme Beeinflussung des Erkennungsbereichs bereitgestellt.

Gemäß einer Ausführungsform ist das Magnetfeld zur Bündelung des Erkennungsbereichs in zumindest eine vorbestimmte Erkennungsrichtung ausgelegt. Insbesondere kann die vorbestimmte Erkennungsrichtung als die räumliche Richtung ausgebildet sein, in die der zumindest eine induktive Sensor die Erkennung von Objekten ausführt. Zusätzlich kann die Bündelung des Erkennungsbereichs in die zumindest eine vorbestimmte Erkennungsrichtung als Vergrößerung des Erkennungsbereichs in die zumindest eine vorbestimmte Erkennungsrichtung verstanden werden. Gemäß einer Ausführungsform kann das Magnetfeld zur Bündelung des Erkennungsbereichs in zwei vorbestimmte Erkennungsrichtungen ausgelegt sein. Auf diese Weise kann der Erkennungsbereich beliebig mit Hilfe des von der Magnetquelle erzeugten Magnetfelds beeinflusst werden.

Gemäß einer Ausführungsform ist das Magnetfeld zur Beschränkung des Erkennungsbereichs in zumindest eine vorbestimmte Beschränkungsrichtung ausgelegt. Insbesondere kann die vorbestimmte Beschränkungsrichtung in einer Ebene im Wesentlichen senkrecht zur vorbestimmten Erkennungsrichtung ausgerichtet sein. Auf diese Weise wird eine Bündelung und/oder Ausrichtung des Magnetfelds ermöglicht.

Gemäß einer Ausführungsform ist die vorbestimmte Beschränkungsrichtung eine seitliche Streuungsrichtung. Zusätzlich kann die seitliche Streuungsrichtung mit einer seitlichen aktiven Fläche des Sensors übereinstimmen. Auf diese Weise wird eine Bündelung und/oder Ausrichtung des Magnetfelds, insbesondere in die vorbestimmte Erkennungsrichtung, ermöglicht. Ferner können metallische Bauteile und/oder Komponenten in der seitlichen Streuungsrichtung des Sensors angeordnet sein, ohne dass es zu eine ungewollten Auslösung des zumindest einen Sensors kommt. Auf diese Weise wird eine ungewollte Auslösung des Sensors aufgrund der metallischen Bauteile und/oder Komponenten effektiv vermieden. Hierbei wird der Erkennungsbereich in die seitliche Streuungsrichtung effektiv minimiert und somit das gesamte Feld, insbesondere seitliche Feld, gebündelt. Zudem wird der potentielle Mindestabstand zum nächstgelegenen metallischen Gegenstand deutlich verringert. Ferner hat das seitliche Feld keinen Einfluss auf den Schaltabstand und somit wird der Schaltabstand in die Erkennungsrichtung beibehalten und nicht beeinflusst, insbesondere nicht verringert.

Gemäß einer Ausführungsform ist die Magnetquelle ein Magnetband. Auf diese Weise wird eine einfach anzubringende Magnetquelle bereitgestellt. Zusätzlich kann das Magnetband als jedes im Wesentlichen dünne und/oder bandartige magnetisierbare Material verstanden werden. Ferner kann die Magnetquelle als ein anisotroper Magnet, insbesondere ein anisotropes Magnetband, ausgebildet sein, wobei der anisotrope Magnet eine Vorzugsrichtung für die Magnetisierung aufweist. Hierbei ist die Magnetisierung ausschließlich in eine vorgegebene Richtung.

Alternativ kann die Magnetquelle als ein isotroper Magnet ausgebildet sein, wohingegen die Richtung der Magnetisierung beliebig ist.

Gemäß einer Ausführungsform ist die externe Oberfläche eine nicht isolierte aktive Fläche des Sensors. Zusätzlich kann die externe Oberfläche eine seitliche nicht isolierte aktive Fläche des Sensors sein. Auf diese Weise werden durch die Anordnung der Magnetquelle auf dieser Fläche die seitlichen Magnetfeldlinien effektiv verringert. Zusätzlich kann durch die Anordnung der Magnetquelle die seitliche Sensibilität des Sensors effektiv verringert. Die seitliche nicht isolierte aktive Fläche des Sensors kann im Wesentlichen senkrecht zur Erkennungsrichtung des Sensors ausgerichtet sein.

Gemäß einer Ausführungsform ist der zumindest eine induktive Sensor ein Näherungssensor. Auf diese Weise kann die Sensoranordnung metallische Objekte mit einer hohen Genauigkeit erkennen.

Gemäß einer Ausführungsform weist die Basis eine Öffnung auf, wobei der zumindest eine Sensor an einem Rand der Öffnung angeordnet und zur Erkennung eines durch die Öffnung eintretenden metallischen Mediums ausgebildet ist. Insbesondere ist die Erkennungsrichtung des zumindest einen Sensors zu einem Zentrum der Öffnung ausgerichtet. Auf diese Weise kann der zumindest eine Sensor effektiv und im Wesentlichen fehlerfrei ein durch die Öffnung eintretendes metallisches Medium erkennen. Zusätzlich kann die Öffnung in der Nähe eines Einzugsrings angeordnet sein oder als Einzugsring ausgebildet sein, wobei der Einzugsring als Eingabeöffnung in einem Einlassbereich eines Verkauf- oder Rücknahmeautomaten verstanden werden kann. Ferner kann der zumindest eine Sensor mit einem vorbestimmten Abstand, insbesondere ein Abstand zwischen 0 cm, insbesondere eine bündige und/oder nahezu bündige Anordnung am Rand, und dem maximalen Schaltabstand des zumindest einen Sensors zum Rand der Öffnung angeordnet sein.

Insbesondere kann der zumindest eine Sensor auf einem Haltewinkel an einem Rand der Öffnung angeordnet sein. Der Haltewinkel kann beispielsweise als kompakter metallischer Winkel ausgebildet sein. Zusätzlich kann der Haltewinkel derart ausgebildet sein, dass der zumindest eine Sensor in die optimale Position gebracht wird zur Erkennung eines durch die Öffnung eintretenden metallischen Mediums. Ferner kann der Haltewinkel zum beabstanden des zumindest eine Sensors von der metallischen Basis ausgebildet sein.

Gemäß einer Ausführungsform ist ein zweiter Sensor an dem Rand angeordnet, wobei die Sensoren gegenüberliegend an dem Rand angeordnet sind, insbesondere um etwa 180° gegenüberliegend, wobei ein beliebiger Winkel eingestellt werden kann. Auf diese Weise wird eine optimale Anordnung mehrere Sensoren bereitgestellt, damit die Sensoranordnung effektiv und im Wesentlichen fehlerfrei ein durch die Öffnung eintretendes metallisches Medium erkennen kann. Insbesondere sind die jeweiligen Erkennungsrichtungen des ersten und zweiten Sensors im Wesentlichen zueinander und/oder zum Zentrum der Öffnung gerichtet.

Gemäß einer Ausführungsform ist ein zweiter Sensor an dem Rand angeordnet, wobei die Sensoren zueinander versetzt an dem Rand angeordnet sind, insbesondere um etwa 90° versetzt. Auf diese Weise wird eine optimale Anordnung mehrere Sensoren bereitgestellt, damit die Sensoranordnung effektiv und im Wesentlichen fehlerfrei ein durch die Öffnung eintretendes metallisches Medium erkennen kann. Insbesondere sind die jeweiligen Erkennungsrichtungen des ersten und zweiten Sensors im Wesentlichen zum Zentrum der Öffnung gerichtet.

Gemäß einer Ausführungsform weist der Verkauf- oder Rücknahmeautomat eine Automatenfront auf, wobei die metallische Basis zumindest einen Abschnitt der Automatenfront bildet, wobei die Öffnung in einem Einlassbereich, insbesondere in der Nähe eines Einzugsrings, der Automatenfront vorgesehen ist. Auf diese Weise wird eine optimale Anordnung einer Sensoranordnung bereitgestellt, damit die Sensoranordnung effektiv und im Wesentlichen fehlerfrei ein durch die Öffnung eintretendes metallisches Medium erkennen kann. Ferner können im Einlassbereich weitere metallische Bauteile und/oder Komponenten angeordnet sein, die zur Funktion des Verkauf- oder Rücknahmeautomat beitragen. Insbesondere kann die Automatenfront als jedes im Wesentlichen flächige Bauteil, dass zur Aufnahme weitere Komponenten ausgebildet ist, verstanden werden. Beispielsweise kann eine Automatenfront auch als Automatenrückseite oder Automatenseitenteil ausgebildet sein.

Gemäß einer Ausführungsform des Verfahrens umfasst der Schritt des Anlegens folgendes: Bereitstellen einer zum Erzeugen des vorbestimmten Magnetfelds ausgebildeten Magnetquelle, und Anordnen der Magnetquelle auf einer externen Oberfläche des Sensors. Insbesondere kann die Magnetquelle ein Magnetband sein. Zusätzlich kann die externe Oberfläche des Sensors eine nicht isolierte aktive Fläche des Sensors, insbesondere seitliche Fläche, sein. Auf diese Weise wird ein einfach durchführbares und kostengünstiges Verfahren bereitgestellt.

Die obigen Ausgestaltungen und Weiterbildungen lassen sich, sofern sinnvoll, beliebig miteinander kombinieren. Insbesondere sind sämtliche Merkmale der Sensoranordnung auf einen Verkaufs- oder Rücknahmeautomaten sowie auf das Verfahren zur Herstellung einer Sensoranordnung in einem oder für einen Verkaufs- oder Rücknahmeautomaten übertragbar, und umgekehrt.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: eine schematische Darstellung einer Sensoranordnung;
- Fig. 2A: eine schematische Darstellung einer Sensoranordnung ohne extern angelegten Magnetfeld;
- Fig. 2B: eine schematische Darstellung einer Sensoranordnung mit extern angelegten Magnetfeld;
- Fig. 3A: eine schematische Detailansicht eines Verkaufs- oder Rücknahmeautomaten gemäß einer Ausführungsform;
- Fig. 3B: eine schematische Detailansicht eines Verkaufs- oder Rücknahmeautomaten gemäß einer weiteren Ausführungsform;
- Fig. 4: perspektivische Ansicht eines Sensors;
- Fig. 5: eine schematische Darstellung eines Verkaufs- oder Rücknahmeautomaten; und
- Fig. 6: ein Ablaufdiagramm eines Verfahrens zur Herstellung einer Sensoranordnung.

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG VON AUSFÜHRUNGSBEISPIELEN

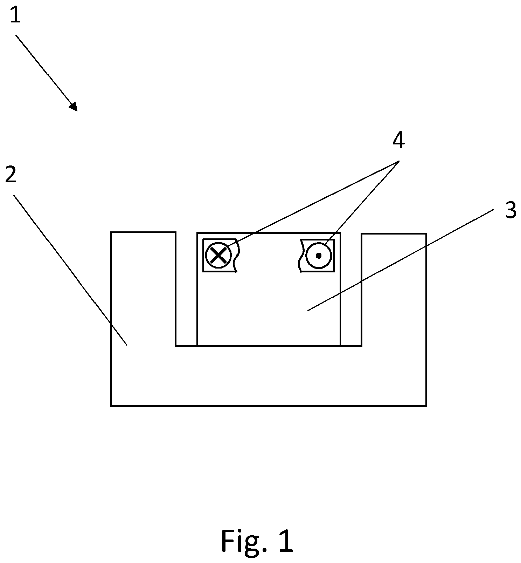

Fig. 1 zeigt eine schematische Darstellung einer Sensoranordnung mit reduzierter Komponentenanzahl.

Es handelt sich hierbei um eine Prinzip-Skizze einer Sensoranordnung 1 für induktive Sensoren mit einer metallischen Basis 2 und zumindest einem nichtbündigen induktiven Sensor 3. Dabei ist der zumindest eine nichtbündige Sensor 3 im Wesentlichen bündig in oder an dem Metall der metallischen Basis 2 angeordnet. Zusätzlich ist ein vorbestimmtes extern angelegtes oder anlegbares Magnetfeld 4 an dem Sensor 3 vorgesehen.

Das vorbestimmte extern angelegte oder anlegbare Magnetfeld 4 und dessen Richtung sind mit dem eingekreisten Punkt und Kreuz angezeigt. Ferner ist die metallische Basis 2 im Wesentlichen als Profil ausgebildet, wobei der zumindest eine Sensor 3 an einer Seite anliegend an der metallischen Basis 2, und an zwei Seiten mit einem Abstand zur metallischen Basis 2 angeordnet ist.

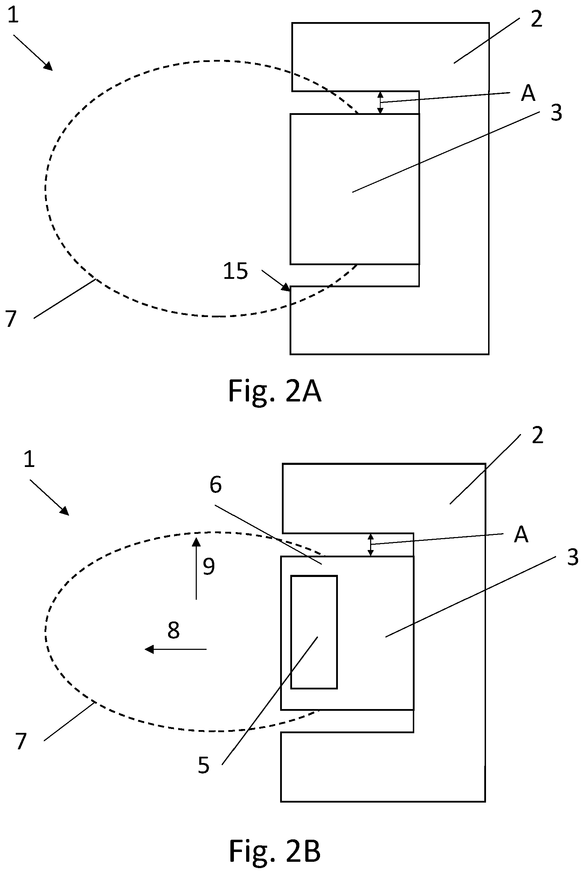

Fig. 2A zeigt eine schematische Darstellung einer Sensoranordnung 1 ohne extern angelegtes Magnetfeld 4.

Die Darstellung von Fig. 2A zeigt eine Sensoranordnung 1, wobei der Erkennungsbereich 7 des zumindest einen Sensors 3 mit der metallischen Basis 2 überlappt. Dies wird durch die Überschneidung 15 angezeigt. In den meisten Datenblättern von induktiven Sensoren, wird ein gewisser Mindestabstand zu einem benachbarten leitfähigen Material, wie z.B. eine metallische Basis 2, angegeben. Der Mindestabstand definiert den erforderlichen räumlichen Abstand, um ein ungewolltes Auslösen des induktiven Sensors zu verhindern.

Ferner ist in Fig. 2A die Überschneidung 15 gezeigt, wobei der Erkennungsbereich 7 des zumindest einen Sensors 3 und die metallische Basis 2 überlappen. Hierbei kommt es zu der bereits erwähnten ungewollten Auslösung des zumindest einen induktiven Sensors 3. Zusätzlich ist ein Abstand A in Fig. 2A anzeigt, wobei der Abstand A die seitliche räumliche Distanz wischen der metallischen Basis 2 und dem zumindest einen Sensor 3 beschreibt. Ferner ist erkennbar, dass der Abstand A nicht einem geforderten Mindestabstand entspricht, da es zu einer Überschneidung 15 kommt. Die in Fig. 2A gezeigt Sensoranordnung 1 würde somit für die abgebildete Anwendung mit dem angezeigtem Abstand A nicht in Frage kommen.

Fig. 2B zeigt eine schematische Darstellung einer Sensoranordnung mit extern angelegten Magnetfeld.

Fig. 2B zeigt eine Sensoranordnung 1 mit einer Magnetquelle 5. Die Magnetquelle 5 ist zum Erzeugen des vorbestimmten Magnetfelds 4 ausgebildet. Zusätzlich ist die Magnetquelle 5 auf einer externen Oberfläche 6 des Sensors 3 angeordnet, wobei das vorbestimmte Magnetfeld 4 zur Beeinflussung eines Erkennungsbereichs 7 des Sensors 3 ausgelegt ist.

Ferner ist das Magnetfeld 4 zur Bündelung des Erkennungsbereichs 7 in zumindest eine vorbestimmte Erkennungsrichtung 8 ausgelegt. Zudem ist das Magnetfeld 4 zur Beschränkung des Erkennungsbereichs 7 in zumindest eine vorbestimmte Beschränkungsrichtung 9 ausgelegt. Dabei ist die vorbestimmte Beschränkungsrichtung 9 eine seitliche Streuungsrichtung.

Die Auswirkung des extern angelegten Magnetfeldes 4 ist deutlich zu erkennen. Damit ist man in der Lage mit einer gezielten Beeinflussung des Erkennungsbereichs 7, bzw. des Magnetfelds 4 eine nahezu bündige Einbauform des zumindest einen induktiven Sensors 3 zu ermöglichen.

Werden die seitlich externen Oberflächen 6 mit einem extern angelegten Magnetfeld 4 versehen, dann werden die seitlich austretenden Magnetfeldlinien und somit das gesamte seitliche Magnetfeld gebündelt und der Mindestabstand nächstgelegenen metallischen Gegenstand kann deutlich verringert werden.

Da das seitliche Feld keinen Einfluss auf den Schaltabstand hat, wird der Schaltabstand beibehalten und nicht beeinflusst.

Durch das Anlegen des externen Magnetfelds 4 ist man in der Lage den seitlich austretenden Erkennungsbereich 7 zu beeinflussen. Wie in Fig. 2B zu erkennen, bleibt der benötigte Abstand A zur metallischen Basis 2 weiterhin bestehen, mit dem Unterschied, dass es zu keiner Überschneidung kommt und daher der zumindest eine induktive Sensor 3 nun nicht mehr ungewollt auslöst.

Durch das gezielte Anlegen eines externen Magnetfeldes 4 ist man in der Lage den zumindest einen Sensor 3 für deutlich mehr Anwendungen zu verwenden. Diese Umlenkung der Magnetfeldlinien hat keinen negativen Einfluss auf den Schaltabstand bzw. den Erkennungsbereich 7.

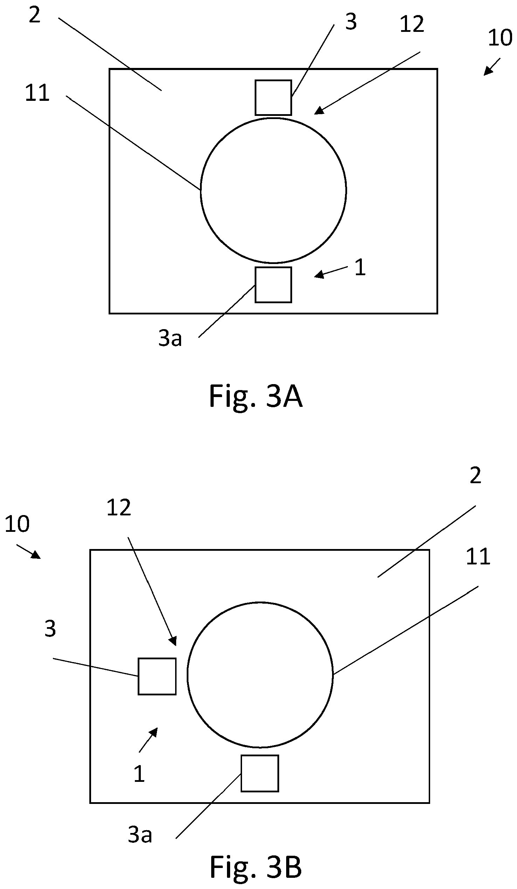

Fig. 3A zeigt eine schematische Detailansicht eines Verkaufs- oder Rücknahmeautomaten gemäß einer Ausführungsform.

Die abgebildete Sensoranordnung 1 umfasst eine Basis 2, die eine Öffnung 11 aufweist. Ferner ist der zumindest eine Sensor 3 an einem Rand 12 der Öffnung 11 angeordnet und zur Erkennung eines durch die Öffnung 11 eintretenden metallischen Mediums M (nicht gezeigt) ausgebildet. Zusätzlich ist ein zweiter Sensor 3a an dem Rand 12 angeordnet, wobei die Sensoren 3,3a gegenüberliegend an dem Rand 12 angeordnet sind. Die Sensoren 3,3a sind insbesondere um etwa 180° gegenüberliegend angeordnet.

Fig. 3B zeigt eine schematische Detailansicht eines Verkaufs- oder Rücknahmeautomaten gemäß einer weiteren Ausführungsform.

Alternativ zu Fig. 3A, ist der zweite Sensor 3a an dem Rand 12 angeordnet, wobei die Sensoren 3,3a zueinander versetzt an dem Rand 12 angeordnet sind, insbesondere um etwa 90° versetzt. Denkbar sind auch weitere Anordnungen der Sensoren insbesondere drei Sensoren jeweils um etwa 120° versetzt.

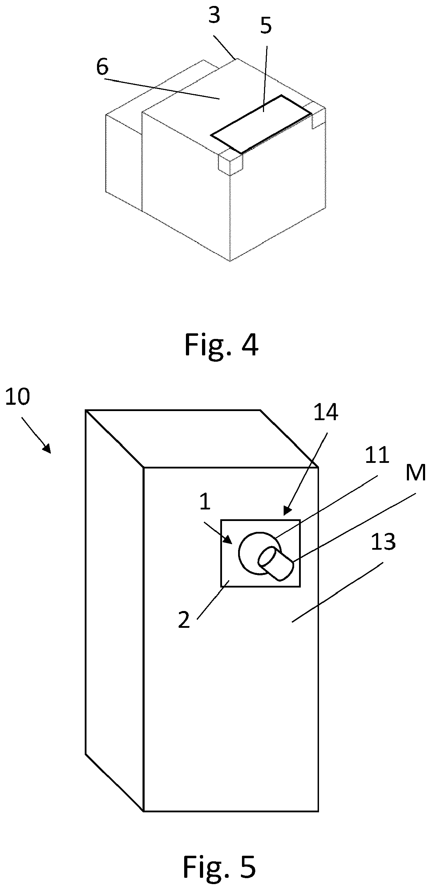

Fig. 4 zeigt perspektivische Ansicht eines Sensors 3.

In Fig. 4 ist erkennbar, dass die Magnetquelle 5 ein Magnetband ist, wobei die externe Oberfläche 6 eine nicht isolierte aktive Fläche des Sensors 3 ist. Zusätzlich ist der abgebildete zumindest eine induktive Sensor 3 ein Näherungssensor.

Fig. 5 zeigt eine schematische Darstellung eines Verkaufs- oder Rücknahmeautomaten 10.

Der Verkaufs- oder Rücknahmeautomat 10 weist eine Sensoranordnung 1 für induktive Sensoren auf. Zusätzlich weist der Verkaufs- oder Rücknahmeautomat 10 eine Automatenfront 13 auf, wobei die metallische Basis 2 zumindest einen Abschnitt der Automatenfront 13 bildet. Ferner ist die Öffnung 11 in einem Einlassbereich 14, insbesondere in der Nähe eines Einwurfrings, der Automatenfront 13 vorgesehen. Darüber hinaus ist zumindest ein Sensor 3 (nicht gezeigt) an einem Rand 12 (nicht gezeigt) der Öffnung 11 angeordnet und zur Erkennung eines durch die Öffnung 11 eintretenden metallischen Mediums M ausgebildet. Das metallische Medium M kann beispielsweise eine metallische Getränkedose sein.

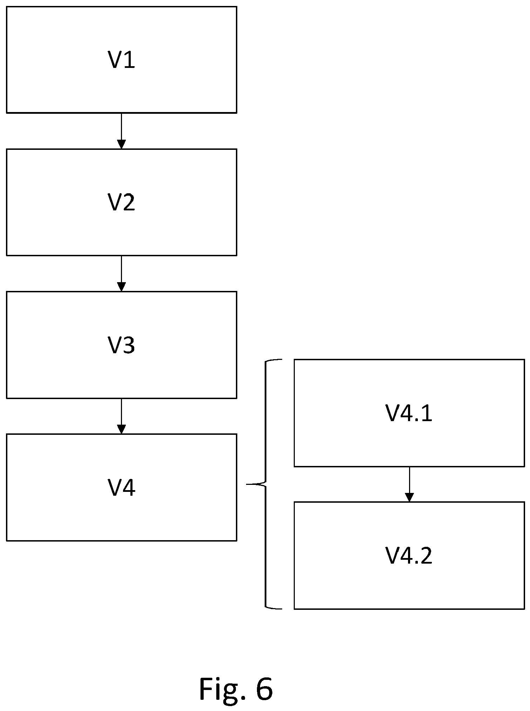

Fig. 6 zeigt ein Ablaufdiagramm eines Verfahrens zur Herstellung einer Sensoranordnung 1.

Das abgebildete Ablaufdiagram des Verfahrens umfasst 4 Verfahrensschritte V1-V4. Die Nummerierung der Verfahrensschritte V1-V4 dient nur zur Unterscheidung der verschiedenen Verfahrensschritte V1-V4 voneinander und impliziert keine Reihenfolge, in der die Verfahrensschritte V1-V4 ausgeführt werden müssen. In diesem Sinne kann die Reihenfolge der Verfahrensschritte V1-V4 kann auch in einer anderen als der in Fig. 6 dargestellten Reihenfolge durchgeführt werden.

Das Verfahren zur Herstellung einer Sensoranordnung 1 umfasst den Schritt des Bereitstellens V1 einer metallischen Basis 2, die zumindest einen Abschnitt einer Automatenfront 13 bildet. Zusätzlich umfasst das Verfahren die Schritte des Bereitstellens V2 zumindest eines nichtbündigen induktiven Sensors 3 und des Anordnens V3 des zumindest einen nichtbündigen induktiven Sensors 3 im Wesentlichen bündig in oder an dem Metall der metallischen Basis 2. Ferner umfasst das Verfahren den Schritt des Anlegens V4 eines vorbestimmten externen Magnetfelds 4 an dem Sensor 3.

Zusätzlich kann der Schritt des Anlegens V4 ein Bereitstellen V4.1 einer zum Erzeugen des vorbestimmten Magnetfelds 4 ausgebildeten Magnetquelle 5 umfassen. Ferner kann der Schritt des Anlegens V4 ein Anordnen V4.2 der Magnetquelle 5 auf einer externen Oberfläche 6 des Sensors 3 umfassen.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

### Bezugszeichenliste

- 1: Sensoranordnung
- 10: Verkaufs- oder Rücknahmeautomat

- 2: metallische Basis
- 3,3a: Sensor
- 4: Magnetfeld
- 5: Magnetquelle
- 6: externe Oberfläche
- 7: Erkennungsbereich
- 8: Erkennungsrichtung
- 9: Beschränkungsrichtung
- 11: Öffnung
- 12: Rand
- 13: Automatenfront
- 14: Einlassbereich
- 15: Überschneidung

- V1-V4.2: Schritte
- M: metallisches Medium
- A: Abstand

## Patentansprüche

1. Sensoranordnung (1) für induktive Sensoren,
mit einer metallischen Basis (2), und
mit zumindest einem nichtbündigen induktiven Sensor (3),
wobei der zumindest eine nichtbündige Sensor (3) im Wesentlichen bündig in oder an dem Metall der metallischen Basis (2) angeordnet ist, und
wobei ein vorbestimmtes extern angelegtes oder anlegbares Magnetfeld (4) an dem Sensor (3) vorgesehen ist.

2. Sensoranordnung nach Anspruch 1,
**dadurch gekennzeichnet,**
**dass** die Sensoranordnung (1) eine Magnetquelle (5) aufweist, die zum Erzeugen des vorbestimmten Magnetfelds (4) ausgebildet ist,
wobei die Magnetquelle (5) auf einer externen Oberfläche (6) des Sensors (3) angeordnet ist.

3. Sensoranordnung nach Anspruch 1 oder 2,
**dadurch gekennzeichnet,**
**dass** das vorbestimmte Magnetfeld (4) zur Beeinflussung eines Erkennungsbereichs (7) des Sensors (3) ausgelegt ist.

4. Sensoranordnung nach Anspruch 3,
**dadurch gekennzeichnet,**
**dass** das Magnetfeld (4) zur Bündelung des Erkennungsbereichs (7) in zumindest eine vorbestimmte Erkennungsrichtung (8) ausgelegt ist.

5. Sensoranordnung nach Anspruch 3 oder 4,
**dadurch gekennzeichnet,**
**dass** das Magnetfeld (4) zur Beschränkung des Erkennungsbereichs (7) in zumindest eine vorbestimmte Beschränkungsrichtung (9) ausgelegt ist, wobei die vorbestimmte Beschränkungsrichtung (9) insbesondere eine seitliche Streuungsrichtung ist.

6. Sensoranordnung nach einem der Ansprüche 2-5, **dadurch gekennzeichnet,**
**dass** die Magnetquelle (5) ein Magnetband ist,

7. Sensoranordnung nach einem der Ansprüche 2-6, **dadurch gekennzeichnet,**
**dass** die externe Oberfläche (6) eine nicht isolierte aktive Fläche des Sensors (3) ist.

8. Sensoranordnung nach einem der vorhergehenden Ansprüche,
**dadurch gekennzeichnet,**
**dass** der zumindest eine induktive Sensor (3) ein Näherungssensor ist.

9. Sensoranordnung nach einem der vorhergehenden Ansprüche,
**dadurch gekennzeichnet,**
**dass** die Basis (2) eine Öffnung (11) aufweist,
wobei der zumindest eine Sensor (3) an einem Rand (12) der Öffnung (11) angeordnet und zur Erkennung eines durch die Öffnung (11) eintretenden metallischen Mediums (M) ausgebildet ist.

10. Sensoranordnung nach Anspruch 9,
**dadurch gekennzeichnet,**
**dass** ein zweiter Sensor (3a) an dem Rand (12) angeordnet ist, wobei die Sensoren (3,3a) gegenüberliegend an dem Rand (12) angeordnet sind, insbesondere um etwa 180° gegenüberliegend.

11. Sensoranordnung nach Anspruch 9, **dadurch gekennzeichnet, dass** ein zweiter Sensor (3a) an dem Rand (12) angeordnet ist, wobei die Sensoren (3,3a) zueinander versetzt an dem Rand (12) angeordnet sind, insbesondere um etwa 90° versetzt.

12. Verkaufs- oder Rücknahmeautomat (10), mit
einer Sensoranordnung (1) für induktive Sensoren nach einem der Ansprüche 1-11.

13. Verkaufs- oder Rücknahmeautomat nach Anspruch 12, **dadurch gekennzeichnet,**
mit einer Automatenfront (13), wobei die metallische Basis (2) zumindest einen Abschnitt der Automatenfront (13) bildet, wobei die Öffnung (11) in einem Einlassbereich (14), insbesondere in der Nähe eines Einwurfrings, der Automatenfront (13) vorgesehen ist.

14. Verfahren zur Herstellung einer Sensoranordnung in einem oder für einen Verkaufs- oder Rücknahmeautomaten, insbesondere eines Verkaufs- oder Rücknahmeautomaten nach Anspruch 12 oder 13, mit den Schritten:
Bereitstellen (VI) einer metallischen Basis (2), die zumindest einen Abschnitt einer Automatenfront (13) bildet;
Bereitstellen (V2) zumindest eines nichtbündigen induktiven Sensors (3);
Anordnen (V3) des zumindest einen nichtbündigen induktiven Sensors (3) im Wesentlichen bündig in oder an dem Metall der metallischen Basis (2); und
Anlegen (V4) eines vorbestimmten externen Magnetfelds (4) an dem Sensor (3).

15. Verfahren nach Anspruch 14,
**dadurch gekennzeichnet,**
**dass** der Schritt des Anlegens (V4) folgendes umfasst:
Bereitstellen (V4.1) einer zum Erzeugen des vorbestimmten Magnetfelds (4) ausgebildeten Magnetquelle (5), und
Anordnen (V4.2) der Magnetquelle (5) auf einer externen Oberfläche (6) des Sensors (3).
